# EUROPEAN PATENT APPLICATION

(11) **EP 4 510 301 A1**
(43) Date of publication of application: **19.02.2025**
(21) Application number: 22948261.7
(22) Date of filing: 28.06.2022
(51) Int. Cl.: H01M 10/60

(54) **ENERGY STORAGE SYSTEM THERMAL MANAGEMENT METHOD AND ENERGY STORAGE SYSTEM**

(71) Applicant: Contemporary Amperex Technology Co., Limited, Ningde, Fujian 352100 (CN)
(72) Inventor: ZUO, Xiyang, Ningde, Fujian 352100 (CN); LI, Zhonghong, Ningde, Fujian 352100 (CN); XU, Jinmei, Ningde, Fujian 352100 (CN); LUO, Guangsheng, Ningde, Fujian 352100 (CN); LI, Lihong, Ningde, Fujian 352100 (CN); WU, Kai, Ningde, Fujian 352100 (CN)
(74) Representative: Rowlands, Stuart Michael
(86) International application number: PCT/CN2022/101723
(87) International publication number: WO 2024/000138

(57) **Abstract**

The embodiments of the present application provide an energy storage system thermal management method and an energy storage system. The method comprises: acquiring state information of an energy storage system, the state information comprising temperature information and charging and discharging information of an energy storage unit of the energy storage system, and also temperature information of a thermal management component of the energy storage system; and according to the state information, determining a thermal management strategy for the energy storage system. The technical solution of the embodiments of the present application allows for reasonably controlling the thermal management system, adjusting the thermal management strategy of the energy storage system, and achieving effective and energy-saving thermal management of the energy storage system.

## Description

### TECHNICAL FIELD

The present application relates to the technical field of energy storage, in particular to a method for thermal management of an energy storage system and an energy storage system.

### BACKGROUND

With the background that the installed capacity for renewable energy power generation is greatly increased due to the national power reform, energy storage technology will play an important role in the five major aspects of an electric power system: generation, transmission, transformation, distribution and consumption, and battery energy storage systems are used more and more widely in the fields of new energy, smart grids, energy-saving technologies, etc.

A lot of energy is stored in a confined space of the battery energy storage system. With the development of high-energy-density battery cells and the increase in the demand for a large capacity in energy storage power stations, the thermal management system of the energy storage system plays an increasingly important role in the consistency and stability of a battery system, and the performance of the energy storage system is greatly affected by its thermal management system. Therefore, how to reasonably control the thermal management system to perform thermal management on the energy storage system is an urgent problem at present.

### SUMMARY

The present application provides a method for thermal management of an energy storage system and an energy storage system, a thermal management system can be reasonably controlled, a thermal management strategy of the energy storage system can be adjusted, and effective and energy-saving thermal management of the energy storage system can be achieved.

In a first aspect, the method for thermal management of an energy storage system is provided and comprises: acquiring state information of the energy storage system, wherein the state information comprises temperature information and charging and discharging information of an energy storage unit of the energy storage system as well as temperature information of a thermal management component of the energy storage system; and determining a thermal management strategy of the energy storage system according to the state information.

In an embodiment of the present application, the thermal management strategy of the energy storage system is determined according to the acquired temperature information and charging and discharging information of the energy storage unit as well as the acquired temperature information of the thermal management component. Compared with the solution of determining the thermal management strategy of the energy storage system according to temperatures of batteries and the ambient temperature of the system in the prior art, the solution in the present application comprehensively considers the temperature information of the energy storage unit and the thermal management component and the charging and discharging information of the energy storage unit, the thermal management strategy of the energy storage system is determined according to such state information, such thermal management strategy is more reasonable, thermal management can be performed on the energy storage system more effectively, the performance of the batteries can be improved, the service life of the batteries can be prolonged, and the unnecessary power consumption of the system in the thermal management process can also be reduced.

In a possible implementation manner, the determining a thermal management strategy of the energy storage system according to the state information comprises: determining a working mode of the thermal management component according to the temperature information of the energy storage unit and the temperature information of the thermal management component; and determining control parameters of the thermal management component in the working mode according to the temperature information and the charging and discharging information of the energy storage unit, wherein the working mode comprises a heating mode, a refrigerating mode or a self-circulation mode.

The temperature is a key factor affecting the performance of the batteries, at an appropriate working temperature, the aging of the batteries can be slowed down, and meanwhile, the best performance of the batteries can be achieved. The working mode of the thermal management component is determined by means of the temperature information of the energy storage unit and the temperature information of the thermal management component, so that thermal management can be performed on the energy storage system timely according to multiple pieces of temperature information of the current energy storage system, and the influence on the performance of the batteries caused by the excessively high or excessively low temperature of the energy storage system can be prevented. Meanwhile, the control parameters of the thermal management component in the working mode are determined by comprehensively considering the temperature information and the charging and discharging information of the energy storage unit, thereby ensuring that the thermal management strategy is more reasonable, thermal management can be performed on the energy storage system more effectively, the performance of the batteries can be improved, and the service life of the batteries can be prolonged.

In a possible implementation manner, the energy storage unit comprises a plurality of batteries; and the determining a working mode of the thermal management component according to the temperature information of the energy storage unit and the temperature information of the thermal management component comprises: determining the working mode of the thermal management component as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component is not less than a third temperature threshold.

The plurality of batteries of the energy storage unit have different magnitudes of internal resistance, different service conditions and different temperatures, so that the first temperature threshold with the relatively high temperature and the second temperature threshold with the relatively low temperature are set; whether the temperature of the battery having the highest temperature in the plurality of batteries is greater than the first temperature threshold and whether the temperature of the battery having the lowest temperature in the plurality of batteries is greater than the second temperature threshold are determined respectively, so that the battery having the highest temperature and the battery having the lowest temperature in the energy storage unit are considered at the same time, and the deviation in setting of determining conditions due to the differences of the temperatures of the batteries is reduced; and whether the temperature of the thermal management component is not less than the third temperature threshold is further considered, the temperatures of the energy storage unit and the thermal management component are considered comprehensively, thus thermal management can be performed on the energy storage system timely according to multiple pieces of temperature information of the current energy storage system, and the influence on the performance of the batteries or the thermal runaway of the energy storage system caused by the excessively high temperature of the energy storage system can be prevented.

In a possible implementation manner, the determining control parameters of the thermal management component in the working mode according to the temperature information and the charging and discharging information of the energy storage unit comprises: determining refrigerating power of the thermal management component in the refrigerating mode according to a temperature change rate and charging and discharging currents of the energy storage unit; and determining a first target temperature of the energy storage unit and a second target temperature of the thermal management component in the refrigerating mode according to the charging and discharging currents of the energy storage unit.

The refrigerating power of the thermal management component in the refrigerating mode is determined by comprehensively considering the temperature change rate and the charging and discharging currents of the energy storage unit, during refrigerating of the thermal management component, by means of the reasonable refrigerating power, thermal management on the energy storage unit can be effectively achieved, and meanwhile, the power consumption of the thermal management component can be reduced. Charging and discharging currents of the batteries are closely related to the temperatures of the batteries, the first target temperature of the energy storage unit and the second target temperature of the thermal management component in the refrigerating mode are determined according to the charging and discharging currents of the energy storage unit, and the more reasonable control parameters of the thermal management component are determined.

In a possible implementation manner, the determining refrigerating power of the thermal management component in the refrigerating mode according to a temperature change rate and charging and discharging currents of the energy storage unit comprises: calculating the refrigerating power of the thermal management component as first refrigerating power according to the temperature change rate of the energy storage unit; calculating the refrigerating power of the thermal management component as second refrigerating power according to the charging and discharging currents of the energy storage unit; determining the refrigerating power of the thermal management component in the refrigerating mode as the first refrigerating power under the circumstance that the first refrigerating power is higher than the second refrigerating power; and determining the refrigerating power of the thermal management component in the refrigerating mode as an average of the first refrigerating power and the second refrigerating power under the circumstance that the first refrigerating power is lower than the second refrigerating power.

The refrigerating power of the thermal management component is calculated according to the temperature change rate and the charging and discharging currents of the energy storage unit respectively, the refrigerating power of the thermal management component is determined by comprehensively considering the calculated refrigerating power, the refrigerating power determined in such manner is more reasonable, and the power consumption of the thermal management component can be reduced while effective cooling treatment is performed on the energy storage system.

In a possible implementation manner, the determining a first target temperature of the energy storage unit in the refrigerating mode according to the charging and discharging currents of the energy storage unit comprises: determining a highest target temperature and a lowest target temperature of the energy storage unit in the refrigerating mode according to the charging and discharging currents of the energy storage unit.

The plurality of batteries of the energy storage unit have different magnitudes of internal resistance, different service conditions and different temperatures, so that the highest target temperature and the lowest target temperature of the energy storage unit are determined according to the charging and discharging currents of the energy storage unit, and the deviation in setting of determining conditions due to the differences of the temperatures of the batteries is reduced.

In a possible implementation manner, the thermal management component stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature.

When the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature, a plurality of temperature conditions of the energy storage system reach preset target temperature conditions, the temperature of the energy storage unit is an appropriate working temperature, the temperature thereof is not required to be adjusted, and thus the thermal management component stops refrigeration.

In a possible implementation manner, the method further comprises: determining charging and discharging states of the energy storage unit according to the charging and discharging currents of the energy storage unit.

In a possible implementation manner, the determining charging and discharging states of the energy storage unit according to the charging and discharging currents of the energy storage unit comprises: determining that the energy storage unit is in the charging and discharging states under the circumstance that absolute values of the charging and discharging currents of the energy storage unit are not less than a first current threshold.

When the absolute values of the charging and discharging currents of the energy storage unit are not less than the first current threshold, it is indicated that the charging and discharging currents of the energy storage unit are relatively large and the energy storage unit is in charging and discharging working states.

In a possible implementation manner, the energy storage unit comprises a plurality of batteries; and the determining a working mode of the thermal management component according to the temperature information of the energy storage unit and the temperature information of the thermal management component comprises: determining the working mode of the thermal management component as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component is not greater than a sixth temperature threshold.

The plurality of batteries of the energy storage unit have different magnitudes of internal resistance, different service conditions and different temperatures, so that the fourth temperature threshold with the relatively high temperature and the fifth temperature threshold with the relatively low temperature are set; whether the temperature of the battery having the highest temperature in the plurality of batteries is less than the fourth temperature threshold and whether the temperature of the battery having the lowest temperature in the plurality of batteries is less than the fifth temperature threshold are determined respectively, so that the battery having the highest temperature and the battery having the lowest temperature in the energy storage unit are considered at the same time, and the deviation in setting of determining conditions due to the differences of the temperatures of the batteries is reduced; and whether the temperature of the thermal management component is not greater than the sixth temperature threshold is further considered, the temperatures of the energy storage unit and the thermal management component are considered comprehensively, thus thermal management can be performed on the energy storage system timely according to multiple pieces of temperature information of the current energy storage system, and the influence on charging and discharging rates of the batteries caused by the excessively low temperature of the energy storage system can be prevented.

In a possible implementation manner, the determining the working mode of the thermal management component as the heating mode comprises: determining the working mode of the thermal management component as a first heating mode under the circumstance that the absolute value of the discharging current of the energy storage unit is not less than a second current threshold.

When the absolute value of the discharging current of the energy storage unit is not less than the second current threshold, it is indicated that the discharging current of the energy storage unit is relatively large and the energy storage unit is in the discharging state, thereby determining the working mode of the thermal management component as the first heating mode when the energy storage unit is in the discharging state.

In a possible implementation manner, the thermal management component comprises a plurality of positive temperature coefficient (PTC) heaters; and the determining control parameters of the thermal management component in the working mode according to the temperature information and the charging and discharging information of the energy storage unit comprises: determining the number of the PTC heaters turned on in the first heating mode according to the temperature change rate of the energy storage unit; and determining a third target temperature of the energy storage unit and a fourth target temperature of the thermal management component in the first heating mode according to the discharging current of the energy storage unit.

The PTC heaters can only be turned on or turned off, and the heating power of the single PTC heater cannot be adjusted, so that the heating power of the thermal management component is controlled by controlling the number of the PTC heaters turned on. The heating power of the thermal management component in the heating mode is determined according to the temperature change rate of the energy storage unit, during heating of the thermal management component, by means of the reasonable heating power, thermal management on the energy storage unit can be effectively achieved, and meanwhile, the power consumption of the thermal management component can be reduced. The charging and discharging currents of the batteries are closely related to the temperatures of the batteries, the third target temperature of the energy storage unit and the fourth target temperature of the thermal management component in the heating mode are determined according to the discharging current of the energy storage unit, and the more reasonable control parameters of the thermal management component are determined.

In a possible implementation manner, the thermal management component stops heating under the circumstances that the temperature of the battery having the lowest temperature in the plurality of batteries is not less than the third target temperature and the temperature of the thermal management component is not less than the fourth target temperature.

When the temperature of the battery having the lowest temperature in the plurality of batteries is not less than the third target temperature and the temperature of the thermal management component is not less than the fourth target temperature, a plurality of temperature conditions of the energy storage system reach preset target temperature conditions, the temperature of the energy storage unit is an appropriate working temperature, the temperature thereof is not required to be adjusted, and thus the thermal management component stops heating.

In a possible implementation manner, the determining the working mode of the thermal management component as the heating mode comprises: determining the working mode of the thermal management component as a second heating mode under the circumstance that the absolute value of the charging current of the energy storage unit is not less than a third current threshold.

When the absolute value of the charging current of the energy storage unit is not less than the third current threshold, it is indicated that the charging current of the energy storage unit is relatively large and the energy storage unit is in the charging state, thereby determining the working mode of the thermal management component as the second heating mode when the energy storage unit is in the charging state.

In a possible implementation manner, the state information further comprises the state of charge (SOC) of the energy storage unit; the thermal management component comprises the plurality of PTC heaters; and the method further comprises: under the circumstance that the SOC of the energy storage unit is not greater than a charge threshold, determining that the plurality of PTC heaters are all turned on to enable the temperature of the energy storage unit to reach a preset working temperature.

When the batteries are in the charging state, the charging rate thereof is greatly related to the temperature of the batteries and the SOC of the batteries, and the charging rate of the batteries can be greatly increased at the appropriate working temperature particularly when the SOC is very low. Therefore, the SOC is used as a determining condition, when the SOC is not greater than the charge threshold, it is determined that the plurality of PTC heaters are all turned on to increase the temperature of the energy storage unit as soon as possible so as to enable the temperature to reach the preset working temperature, thereby increasing the charging rate of the batteries.

In a possible implementation manner, the determining control parameters of the thermal management component in the working mode according to the temperature information and the charging and discharging information of the energy storage unit comprises: under the circumstance that the temperature of the energy storage unit reaches the preset working temperature, determining the number of the PTC heaters turned on in the second heating mode according to the temperature change rate of the energy storage unit; and determining a fifth target temperature of the energy storage unit and a sixth target temperature of the thermal management component in the second heating mode according to the charging current of the energy storage unit, wherein the fifth target temperature is greater than the preset working temperature.

When the temperature of the energy storage unit reaches the preset working temperature, the plurality of PTC heaters of the thermal management component are not required to be completely turned on, at this moment, the heating power of the thermal management component in the heating mode is determined according to the temperature change rate of the energy storage unit, during heating of the thermal management component, by means of the reasonable heating power, thermal management on the energy storage unit can be effectively achieved, and meanwhile, the power consumption of the thermal management component can be reduced. The charging and discharging currents of the batteries are closely related to the temperatures of the batteries, the fifth target temperature of the energy storage unit and the sixth target temperature of the thermal management component in the heating mode are determined according to the charging current of the energy storage unit, and the more reasonable control parameters of the thermal management component are determined.

In a possible implementation manner, the thermal management component stops heating under the circumstances that the temperature of the battery having the lowest temperature in the plurality of batteries is not less than the fifth target temperature and the temperature of the thermal management component is not less than the sixth target temperature.

When the temperature of the battery having the lowest temperature in the plurality of batteries is not less than the fifth target temperature and the temperature of the thermal management component is not less than the sixth target temperature, a plurality of temperature conditions of the energy storage system reach preset target temperature conditions, the temperature of the energy storage unit is an appropriate working temperature, the temperature thereof is not required to be adjusted, and thus the thermal management component stops heating.

In a possible implementation manner, the method further comprises: determining the working mode of the thermal management component as the self-circulation mode under the circumstances that the energy storage unit is in a working state and the temperature of the energy storage unit and the temperature of the thermal management component reach the target temperatures.

The self-circulation mode means that the thermal management component is in a standby state and cannot perform thermal management on the energy storage unit, when the temperature of the energy storage unit and the temperature of the thermal management component reach the target temperatures and the energy storage unit and the thermal management component continue to work, the thermal management component is not required to perform thermal management on the energy storage unit.

In a possible implementation manner, the thermal management component is in an off state under the circumstance that the energy storage unit is in a standing state.

When the energy storage unit does not work and is in the standing state, the thermal management component is also not required to be turned on, and thus the power consumption of the system can be reduced.

In a second aspect, the energy storage system is provided and comprises: an energy storage unit, a thermal management component and a control module, wherein the control module is configured to acquire state information of the energy storage system and to determine a thermal management strategy of the energy storage system according to the state information, and the state information comprises temperature information and charging and discharging information of the energy storage unit as well as temperature information of the thermal management component.

In a possible implementation manner, the control module is configured to determine a working mode of the thermal management component according to the temperature information of the energy storage unit and the temperature information of the thermal management component, and to determine control parameters of the thermal management component in the working mode according to the temperature information and the charging and discharging information of the energy storage unit, wherein the working mode comprises a heating mode or a refrigerating mode.

In a possible implementation manner, the control module is configured to determine the working mode of the thermal management component as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component is not less than a third temperature threshold.

In a possible implementation manner, the control module is configured to determine refrigerating power of the thermal management component in the refrigerating mode according to a temperature change rate and charging and discharging currents of the energy storage unit, and to determine a first target temperature of the energy storage unit and a second target temperature of the thermal management component in the refrigerating mode according to the charging and discharging currents of the energy storage unit.

In a possible implementation manner, the control module is configured to calculate the refrigerating power of the thermal management component as first refrigerating power according to the temperature change rate of the energy storage unit, to calculate the refrigerating power of the thermal management component as second refrigerating power according to the charging and discharging currents of the energy storage unit, to determine the refrigerating power of the thermal management component in the refrigerating mode as the first refrigerating power under the circumstance that the first refrigerating power is higher than the second refrigerating power, and to determine the refrigerating power of the thermal management component in the refrigerating mode as an average of the first refrigerating power and the second refrigerating power under the circumstance that the first refrigerating power is lower than the second refrigerating power.

In a possible implementation manner, the first target temperature comprises a highest target temperature and a lowest target temperature; and the control module is configured to determine the highest target temperature and the lowest target temperature of the energy storage unit in the refrigerating mode according to the charging and discharging currents of the energy storage unit.

In a possible implementation manner, the thermal management component stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature.

In a possible implementation manner, the control module is also configured to determine charging and discharging states of the energy storage unit according to the charging and discharging currents of the energy storage unit.

In a possible implementation manner, the control module is configured to determine that the energy storage unit is in the charging and discharging states under the circumstance that absolute values of the charging and discharging currents of the energy storage unit are not less than a first current threshold.

In a possible implementation manner, the energy storage unit comprises the plurality of batteries; and the control module is configured to determine the working mode of the thermal management component as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component is not greater than a sixth temperature threshold.

In a possible implementation manner, the control module is configured to determine the working mode of the thermal management component as a first heating mode under the circumstance that the absolute value of the discharging current of the energy storage unit is not less than a second current threshold.

In a possible implementation manner, the thermal management component comprises a plurality of PTC heaters; and the control module is configured to determine the number of the PTC heaters turned on in the first heating mode according to the temperature change rate of the energy storage unit, and to determine a third target temperature of the energy storage unit and a fourth target temperature of the thermal management component in the first heating mode according to the discharging current of the energy storage unit.

In a possible implementation manner, the thermal management component stops heating under the circumstances that the temperature of the battery having the lowest temperature in the plurality of batteries is not less than the third target temperature and the temperature of the thermal management component is not less than the fourth target temperature.

In a possible implementation manner, the control module is configured to determine the working mode of the thermal management component as a second heating mode under the circumstance that the absolute value of the charging current of the energy storage unit is not less than a third current threshold.

In a possible implementation manner, the state information further comprises the SOC of the energy storage unit; the thermal management component comprises the plurality of PTC heaters; and the control module is also configured to determine that the plurality of PTC heaters are all turned on to enable the temperature of the energy storage unit to reach a preset working temperature under the circumstance that the SOC of the energy storage unit is not greater than a charge threshold.

In a possible implementation manner, the control module is configured to determine the number of the PTC heaters turned on in the second heating mode according to the temperature change rate of the energy storage unit under the circumstance that the temperature of the energy storage unit reaches the preset working temperature, and to determine a fifth target temperature of the energy storage unit and a sixth target temperature of the thermal management component in the second heating mode according to the charging current of the energy storage unit.

In a possible implementation manner, the thermal management component stops heating under the circumstances that the temperature of the battery having the lowest temperature in the plurality of batteries is not less than the fifth target temperature and the temperature of the thermal management component is not less than the sixth target temperature.

In a possible implementation manner, the working mode of the thermal management component is determined as a self-circulation mode under the circumstances that the energy storage unit is in a working state and the temperature of the energy storage unit and the temperature of the thermal management component reach the target temperatures.

In a possible implementation manner, the thermal management component is in an off state under the circumstance that the energy storage unit is in a standing state.

In a third aspect, a device for thermal management of an energy storage system is provided and comprises a processor and a memory, wherein the memory is configured to store a computer program; and the processor is configured to call the computer program so as to enable the device to implement the first aspect or the method according to any possible implementation manner of the first aspect.

In a fourth aspect, a readable storage medium is provided, and the readable storage medium stores a computer program which, when being executed by a computing device, enables the computing device to implement the first aspect or the method according to any possible implementation manner of the first aspect.

The present application provides the method for thermal management of the energy storage system, the thermal management strategy of the energy storage system is determined according to the acquired temperature information and charging and discharging information of the energy storage unit as well as the acquired temperature information of the thermal management component. Compared with the solution of determining the thermal management strategy of the energy storage system according to the temperatures of the batteries and the ambient temperature of the system in the prior art, the solution in the present application comprehensively considers the temperature information of the energy storage unit and the thermal management component and the charging and discharging information of the energy storage unit, the thermal management strategy of the energy storage system is determined according to such state information, such thermal management strategy is more reasonable, thermal management can be performed on the energy storage system more effectively, the performance of the batteries can be improved, the service life of the batteries can be prolonged, and the unnecessary power consumption of the system in the thermal management process can also be reduced.

### BRIEF DESCRIPTION OF THE DRAWINGS

In order to explain technical solutions of embodiments of the present application more clearly, drawings needed in the embodiments of the present application will be briefly introduced below. It will be apparent that the drawings in the following description are only some embodiments of the present application, and for those of ordinary skill in the art, other drawings can be obtained according to these drawings without involving any inventive effort.
FIG. 1 is a schematic diagram of an energy storage system disclosed in an embodiment of the present application;
FIG. 2 is a schematic flow chart of a method for thermal management of an energy storage system disclosed in an embodiment of the present application;
FIG. 3 is a schematic flow chart of a method for thermal management of an energy storage system disclosed in an embodiment of the present application;
FIG. 4 is a schematic flow chart of a method for thermal management of an energy storage system disclosed in an embodiment of the present application;
FIG. 5 is a schematic flow chart of a method for thermal management of an energy storage system disclosed in an embodiment of the present application;
FIG. 6 is a schematic flow chart of a method for thermal management of an energy storage system disclosed in an embodiment of the present application;
FIG. 7 is a schematic flow chart of a method for thermal management of an energy storage system disclosed in an embodiment of the present application;
FIG. 8 is a schematic diagram of an energy storage system disclosed in an embodiment of the present application; and
FIG. 9 is a schematic diagram of a device for thermal management of an energy storage system disclosed in an embodiment of the present application.

### DETAILED DESCRIPTION OF THE EMBODIMENTS

The implementation of the present application is further described in detail below with reference to the accompanying drawings and embodiments. The detailed description of the embodiments and the accompanying drawings below are intended to illustrate the principles of the present application by examples, but are not intended to limit the scope of the present application, that is, the present application is not limited to the described embodiments.

In the description of the present application, it should be noted that, unless otherwise noted, "a plurality of" means two or more; and orientation or positional relationships indicated by the terms "upper", "lower", "left", "right", "inner", "outer", and the like are only for the convenience of description of the present application and simplification of description rather than indicating or implying that the referenced device or element must have a particular orientation or be constructed and operated in a particular orientation, and thus are not to be construed as limiting the present application. In addition, the terms "first", "second", "third", and the like are used for descriptive purposes only and are not to be construed as indicating or implying relative importance. "Vertical" is not strictly vertical, but within the allowable range of error. "Parallel" is not strictly parallel, but within the allowable range of error.

Orientation words appearing in the following description are all directions shown in the drawings and do not limit the specific structure of the present application. In the description of the present application, it should also be noted that, unless otherwise expressly specified and limited, the terms "mounted", "connected" and "attached" should be understood in a broad sense, for example, it can be "fixedly connected" or "detachably connected", or "integrally connected"; and it can be "directly connected" or "indirectly connected by means of an intermediate medium". The specific meanings of the above terms in the present application may be understood by those of ordinary skill in the art depending on specific circumstances.

The term "and/or" in the present application is simply a description of the association relationship of the associated objects, indicating that there may be three relationships, for example, A and/or B may indicate that A exists alone, A and B exist at the same time, and B exists alone. In addition, the character "/" in the present application generally means that the associated objects are in an "or" relationship.

With the background that the installed capacity for renewable energy power generation is greatly increased due to the national power reform, an energy storage technology will play an important role in the five major aspects of an electric power system: generation, transmission, transformation, distribution and consumption. Battery energy storage systems are used more and more widely in the fields of new energy, smart grids, energy-saving technologies, etc.

A lot of energy is stored in a confined space of the battery energy storage system, which has the dangerous nature. In addition, the "thermal runaway" is a root cause for potential safety hazards of lithium ion batteries, and chain reactions of side reactions caused by small organic molecules lead to the thermal runaway of the batteries. With the development of high-energy-density battery cells and the increase in the demand for a large capacity in energy storage power stations, the thermal management system of the energy storage system plays an increasingly important role in the consistency and stability of a battery system, and the performance of the energy storage system is greatly affected by its thermal management system.

Thermal management on the energy storage system by the thermal management system of the existing battery energy storage system is mainly based on the temperatures of the batteries and does not consider charging and discharging states of the batteries and the change conditions of the states of the batteries in the thermal management process, resulting in the deviation of the thermal management on the energy storage system by the thermal management system, reducing the performance of the batteries of the energy storage system, and shortening the service life of the batteries.

In view of this, the present application provides a method for thermal management of an energy storage system, a thermal management strategy of the energy storage system is determined according to acquired temperature information and charging and discharging information of an energy storage unit as well as acquired temperature information of a thermal management component. The solution in the present application comprehensively considers the temperature information of the energy storage unit and the thermal management component and the charging and discharging information of the energy storage unit, the thermal management strategy of the energy storage system is determined according to such state information, such thermal management strategy is more reasonable, thermal management can be performed on the energy storage system more effectively, the performance of the batteries can be improved, the service life of the batteries can be prolonged, and the unnecessary power consumption of the system in the thermal management process can also be reduced.

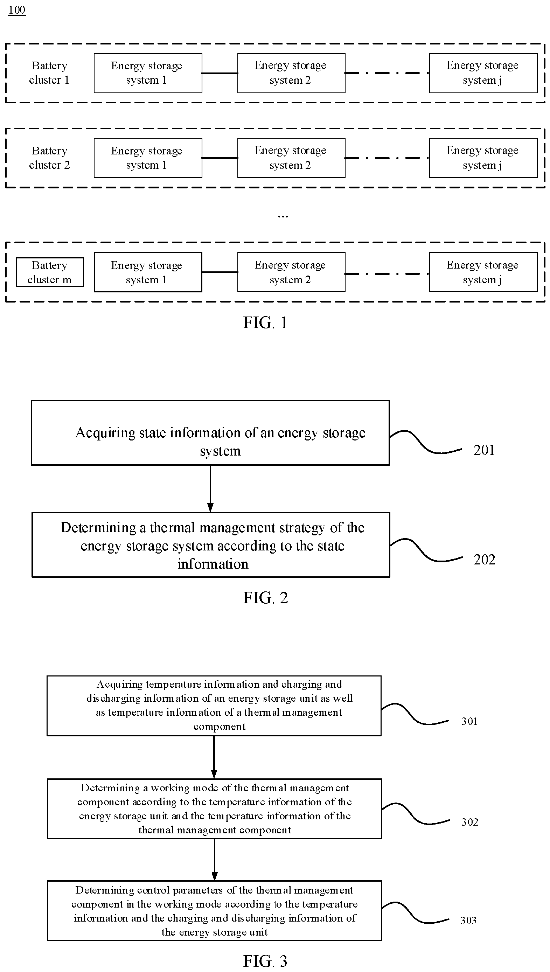

FIG. 1 is a schematic diagram of an energy storage system 100 provided in the present application.

The energy storage system 100 includes a plurality of battery clusters, such as the battery cluster 1 to the battery cluster m shown in FIG. 1, where m may be a natural number greater than 1, that is, the number of the battery clusters may be flexibly adjusted according to the energy storage capacity in practical applications, the number of battery clusters may be appropriately increased if the energy storage capacity is large, and the number of battery clusters may be appropriately reduced if the energy storage capacity is small.

Each battery cluster includes at least two battery energy storage systems (ESS) connected in series, such as the energy storage system 1 to the energy storage system j in FIG. 1, where j can be a natural number greater than or equal to 2. Each ESS includes several energy storage elements connected in series or in parallel so as to form a smallest energy storage and management unit. In order to achieve detection and control of the energy storage system, a battery management system (BMS) will be designed in each of the energy storage systems and the battery clusters to monitor battery information such as the SOC, temperature, current, etc. of a battery and to perform real-time information exchange with an upper energy management system (EMS) or a power convert system (PCS) so as to manage and control the whole battery energy storage system.

FIG. 2 is a schematic flow chart of a method for thermal management of an energy storage system disclosed in an embodiment of the present application. The energy storage system may be the energy storage system 100 as shown in FIG. 1.

Step 201 includes acquiring state information of the energy storage system.

The state information includes temperature information and charging and discharging information of an energy storage unit of the energy storage system as well as temperature information of a thermal management component of the energy storage system.

The thermal management component of the energy storage system can perform thermal management on the energy storage unit of the energy storage system, for example, said component can cool the energy storage unit when the temperature of said unit is excessively high, and can heat the energy storage unit when said unit needs to be heated. The thermal management component may include a water cooling unit, the water cooling unit can be controlled to be in a refrigerating mode to cool the energy storage unit, and the water cooling unit can be controlled to be in a heating mode to heat the energy storage unit. The thermal management component may further include PTC heaters, and the PTC heaters may generate heat to heat the energy storage unit when said unit needs to be heated.

Step 202 includes determining a thermal management strategy of the energy storage system according to the state information.

In an embodiment of the present application, the thermal management strategy of the energy storage system is determined according to the acquired temperature information and charging and discharging information of the energy storage unit as well as the acquired temperature information of the thermal management component. Compared with the solution of determining the thermal management strategy of the energy storage system according to the temperatures of the batteries and the ambient temperature of the system in the prior art, the solution in the present application comprehensively considers the temperature information of the energy storage unit and the thermal management component and the charging and discharging information of the energy storage unit, the thermal management strategy of the energy storage system is determined according to such state information, such thermal management strategy is more reasonable, thermal management can be performed on the energy storage system more effectively, the performance of the batteries can be improved, the service life of the batteries can be prolonged, and the unnecessary power consumption of the system in the thermal management process can also be reduced.

Optionally, in an embodiment of the present application, the temperature information of the energy storage unit and the thermal management component can be acquired by means of temperature sensors, and the temperature sensor for acquiring the temperature information of the energy storage unit and the temperature sensor for acquiring the temperature information of the thermal management component can be arranged separately, can also be arranged integrally, and further, can be integrated with the BMS, which is not limited in the present application.

Optionally, in an embodiment of the present application, the charging and discharging information of the energy storage unit can be acquired by means of electrical detection devices such as a current sensor, a voltage sensor, etc., and the electrical detection devices such as the current sensor, the voltage sensor, etc. can be arranged separately, can also be arranged integrally, and further, can be integrated with the BMS, which is not limited in the present application.

FIG. 3 is a schematic flow chart of a method for thermal management of an energy storage system disclosed in another embodiment of the present application.

Step 301 includes acquiring temperature information and charging and discharging information of an energy storage unit as well as temperature information of a thermal management component.

Step 302 includes determining a working mode of the thermal management component according to the temperature information of the energy storage unit and the temperature information of the thermal management component.

Step 303 includes determining control parameters of the thermal management component in the working mode according to the temperature information and the charging and discharging information of the energy storage unit.

The temperature is a key factor affecting the performance of the batteries, at an appropriate working temperature, the aging of the batteries can be slowed down, and meanwhile, the best performance of the batteries can be achieved. The working mode of the thermal management component is determined by means of the temperature information of the energy storage unit and the temperature information of the thermal management component, so that thermal management can be performed on the energy storage system timely according to multiple pieces of temperature information of the current energy storage system, and the influence on the performance of the batteries caused by the excessively high or excessively low temperature of the energy storage system can be prevented. Meanwhile, the control parameters of the thermal management component in the working mode are determined by comprehensively considering the temperature information and the charging and discharging information of the energy storage unit, thereby ensuring that the thermal management strategy is more reasonable, thermal management can be performed on the energy storage system more effectively, the performance of the batteries can be improved, and the service life of the batteries can be prolonged.

Optionally, in an embodiment of the present application, an energy storage unit includes a plurality of batteries.

In the present application, each battery refers to a physical module that includes one or more battery cells to provide electric energy. For example, each battery provided in the present application may include a battery module or a battery pack. Each battery generally includes a box body for encapsulating the one or more battery cells. The box body can prevent a liquid or other foreign matter from affecting charging or discharging of the battery cell.

In some embodiments, the battery cells may include lithium ion secondary batteries, lithium ion primary batteries, lithium sulfur batteries, sodium lithium ion batteries, sodium ion batteries or magnesium ion batteries, which are not limited in the embodiments of the present application. Usually, the battery cells can also be referred to as cells. The battery cells may be cylindrical, flat, rectangular or in other regular or irregular shapes. The technical solution of the embodiment of the present application may be applied to the battery cells in any shape.

Each battery cell includes an electrode assembly and an electrolyte, and the electrode assembly includes a positive plate, a negative plate and a diaphragm. The battery cell mainly works by relying on metal ions moving between the positive plate and the negative plate. The positive plate includes positive current collectors and a positive active substance layer, the positive active substance layer coats surfaces of the positive current collectors, the current collectors not coated with the positive active substance layer protrude out of the current collectors coated with the positive active substance layer, and the current collectors not coated with the positive active substance layer serve as positive tabs. The lithium ion battery is taken as an example, the positive current collectors may be made of aluminum, and a positive active substance may be lithium cobaltate, lithium iron phosphate, ternary lithium or lithium manganate. The negative plate includes negative current collectors and a negative active substance layer, the negative active substance layer coats surfaces of the negative current collectors, the current collectors not coated with the negative active substance layer protrude out of the current collectors coated with the negative active substance layer, and the current collectors not coated with the negative active substance layer serve as negative tabs. The negative current collectors may be made of copper, and a negative active substance may be carbon or silicon. In order to ensure passing of a large current without fusing, a plurality of positive tabs are provided and are stacked together, and a plurality of negative tabs are provided and are stacked together. The diaphragm may be, for example, made of polypropylene (PP) or polyethylene (PE). In addition, the electrode assembly may be in a wound structure or a laminated structure, and the embodiment of the present application is not limited to this.

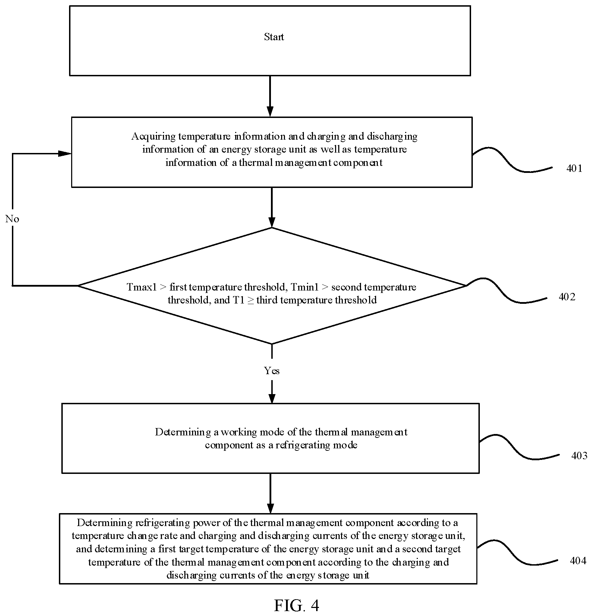

Optionally, in an embodiment of the present application, the working mode of the thermal management component may be a refrigerating mode. Specifically, the working mode of the thermal management component is determined as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component is not less than a third temperature threshold. Reference is made to FIG. 4 which is a schematic flow chart of a method for thermal management of an energy storage system disclosed in an embodiment of the present application. Step 401 in FIG. 4 is similar to Step 301 in the above-mentioned embodiment, reference can be made to the above-mentioned embodiment, and for brevity, this step will not be repeated here.

Step 402 includes determining whether the temperature Tₘₐₓ₁ of the battery having the highest temperature in the plurality of batteries is greater than the first temperature threshold, whether the temperature Tₘᵢₙ₁ of the battery having the lowest temperature in the plurality of batteries is greater than the second temperature threshold, and whether the temperature T1 of the thermal management component is not less than the third temperature threshold.

The first temperature threshold, the second temperature threshold and the third temperature threshold are temperature parameters preset by the energy storage system. The plurality of batteries of the energy storage unit have different magnitudes of internal resistance, different service conditions and different temperatures, so that the first temperature threshold with the relatively high temperature and the second temperature threshold with the relatively low temperature are set; whether the temperature Tₘₐₓ₁ of the battery having the highest temperature in the plurality of batteries is greater than the first temperature threshold and whether the temperature Tₘᵢₙ₁ of the battery having the lowest temperature in the plurality of batteries is greater than the second temperature threshold are determined respectively, so that the battery having the highest temperature and the battery having the lowest temperature in the energy storage unit are considered at the same time, and the deviation in setting of determining conditions due to the differences of the temperatures of the batteries is reduced; and whether the temperature T1 of the thermal management component is not less than the third temperature threshold is further considered, the temperatures of the energy storage unit and the thermal management component are considered comprehensively, thus thermal management can be performed on the energy storage system timely according to multiple pieces of temperature information of the current energy storage system, and the influence on the performance of the batteries or the thermal runaway of the energy storage system caused by the excessively high temperature of the energy storage system can be prevented. The temperature parameters of the first temperature threshold, the second temperature threshold and the third temperature threshold include fixed values, modifiable values, values determined through table lookup, and values determined through functional relationships, which are not limited in the embodiment of the present application.

Step 403 includes determining the working mode of the thermal management component as the refrigerating mode under the circumstances that the temperature Tₘₐₓ₁ is greater than the first temperature threshold, the temperature Tₘᵢₙ₁ is greater than the second temperature threshold, and the temperature T₁ is not less than the third temperature threshold.

When the temperature Tₘₐₓ₁ is greater than the first temperature threshold, the temperature Tₘᵢₙ₁ is greater than the second temperature threshold, and the temperature T₁ is not less than the third temperature threshold, it is indicated that the temperature of the energy storage unit is relatively high, and the temperature of the thermal management component for performing thermal management on the energy storage unit is also relatively high. In order to avoid the thermal runaway of the energy storage unit, the energy storage system needs to be cooled, so that the working mode of the thermal management component is the refrigerating mode, and the energy storage unit is cooled.

Step 404 includes determining refrigerating power of the thermal management component in the refrigerating mode according to a temperature change rate and charging and discharging currents of the energy storage unit, and determining a first target temperature of the energy storage unit and a second target temperature of the thermal management component in the refrigerating mode according to the charging and discharging currents of the energy storage unit.

The refrigerating power of the thermal management component in the refrigerating mode is determined by comprehensively considering the temperature change rate and the charging and discharging currents of the energy storage unit, during refrigerating of the thermal management component, by means of the reasonable refrigerating power, thermal management on the energy storage unit can be effectively achieved, and meanwhile, the power consumption of the thermal management component can be reduced. The charging and discharging currents of the batteries are closely related to the temperatures of the batteries, the first target temperature of the energy storage unit and the second target temperature of the thermal management component in the refrigerating mode are determined according to the charging and discharging currents of the energy storage unit, and the more reasonable control parameters of the thermal management component are determined.

Optionally, in an embodiment of the present application, a method for determining refrigerating power of a thermal management component in a refrigerating mode according to a temperature change rate and charging and discharging currents of an energy storage unit may include: calculating the refrigerating power of the thermal management component as first refrigerating power according to the temperature change rate of the energy storage unit; calculating the refrigerating power of the thermal management component as second refrigerating power according to the charging and discharging currents of the energy storage unit; determining the refrigerating power of the thermal management component in the refrigerating mode as the first refrigerating power under the circumstance that the first refrigerating power is higher than the second refrigerating power; and determining the refrigerating power of the thermal management component in the refrigerating mode as an average of the first refrigerating power and the second refrigerating power under the circumstance that the first refrigerating power is lower than the second refrigerating power.

The refrigerating power of the thermal management component is calculated according to the temperature change rate and the charging and discharging currents of the energy storage unit respectively, the refrigerating power of the thermal management component is determined by comprehensively considering the calculated refrigerating power, the refrigerating power determined in such manner is more reasonable, and the power consumption of the thermal management component can be reduced while effective cooling treatment is performed on the energy storage system.

Optionally, in an embodiment of the present application, the first target temperature of the energy storage unit includes a highest target temperature and a lowest target temperature, that is, the highest target temperature and the lowest target temperature of the energy storage unit and the second target temperature of the thermal management component in the refrigerating mode are determined according to the charging and discharging currents of the energy storage unit. The thermal management component stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature.

When the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature, a plurality of temperature conditions of the energy storage system reach preset target temperature conditions, the temperature of the energy storage unit is an appropriate working temperature, the temperature thereof is not required to be adjusted, and thus the thermal management component stops refrigeration.

Optionally, in an embodiment of the present application, charging and discharging states of the energy storage unit can also be determined according to the charging and discharging currents of the energy storage unit.

Specifically, it is determined that the energy storage unit is in the charging and discharging states under the circumstance that absolute values of the charging and discharging currents of the energy storage unit are not less than a first current threshold.

The first current threshold is a current parameter preset by the energy storage system, and when the absolute values of the charging and discharging currents of the energy storage unit are not less than the first current threshold, it is indicated that the charging and discharging currents of the energy storage unit are relatively large and the energy storage unit is in charging and discharging working states. The current parameter of the first current threshold includes a fixed value, a modifiable value, a value determined through table lookup, and a value determined through functional relationships, which is not limited in the embodiment of the present application.

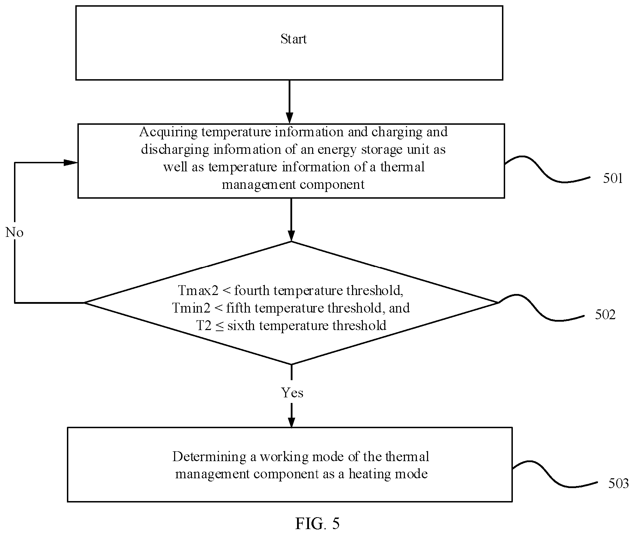

Optionally, in an embodiment of the present application, the working mode of the thermal management component may be a heating mode. Specifically, the working mode of the thermal management component is determined as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component is not greater than a sixth temperature threshold. Reference is made to FIG. 5, Step 501 in FIG. 5 is similar to Step 401 in the above-mentioned embodiment, reference can be made to the above-mentioned embodiment, and for brevity, this step will not be repeated here.

Step 502 includes determining whether the temperature Tₘₐₓ₂ of the battery having the highest temperature in the plurality of batteries is less than the fourth temperature threshold, whether the temperature Tₘᵢₙ₂ of the battery having the lowest temperature in the plurality of batteries is less than the fifth temperature threshold, and whether the temperature T2 of the thermal management component is not greater than the sixth temperature threshold.

The fourth temperature threshold, the fifth temperature threshold and the sixth temperature threshold are temperature parameters preset by the energy storage system. The plurality of batteries of the energy storage unit have different magnitudes of internal resistance, different service conditions and different temperatures, so that the fourth temperature threshold with the relatively high temperature and the fifth temperature threshold with the relatively low temperature are set; whether the temperature Tₘₐₓ₂ of the battery having the highest temperature in the plurality of batteries is less than the fourth temperature threshold and whether the temperature Tₘᵢₙ₂ of the battery having the lowest temperature in the plurality of batteries is less than the fifth temperature threshold are determined respectively, so that the battery having the highest temperature and the battery having the lowest temperature in the energy storage unit are considered at the same time, and the deviation in setting of determining conditions due to the differences of the temperatures of the batteries is reduced; and whether the temperature T₂ of the thermal management component is not greater than the sixth temperature threshold is further considered, the temperatures of the energy storage unit and the thermal management component are considered comprehensively, thus thermal management can be performed on the energy storage system timely according to multiple pieces of temperature information of the current energy storage system, and the influence on charging and discharging rates of the batteries caused by the excessively low temperature of the energy storage system can be prevented. The temperature parameters of the fourth temperature threshold, the fifth temperature threshold and the sixth temperature threshold include fixed values, modifiable values, values determined through table lookup, and values determined through functional relationships, which are not limited in the embodiment of the present application.

Step 503 includes determining the working mode of the thermal management component as the heating mode under the circumstances that the temperature Tₘₐₓ₂ is less than the fourth temperature threshold, the temperature Tₘᵢₙ₂ is less than the fifth temperature threshold, and the temperature T₂ is not greater than the sixth temperature threshold.

When the temperature Tₘₐₓ₂ is less than the fourth temperature threshold, the temperature Tₘᵢₙ₂ is less than the fifth temperature threshold, and the temperature T₂ is not greater than the sixth temperature threshold, it is indicated that the temperature of the energy storage unit is relatively low, the temperature of the thermal management component for performing thermal management on the energy storage unit is also relatively low, and the energy storage unit cannot be heated effectively. The low temperature of the energy storage unit will reduce the charging or discharging rate of the energy storage unit, and the energy storage system needs to be heated, so that the working mode of the thermal management component is the heating mode, and the energy storage unit is heated.

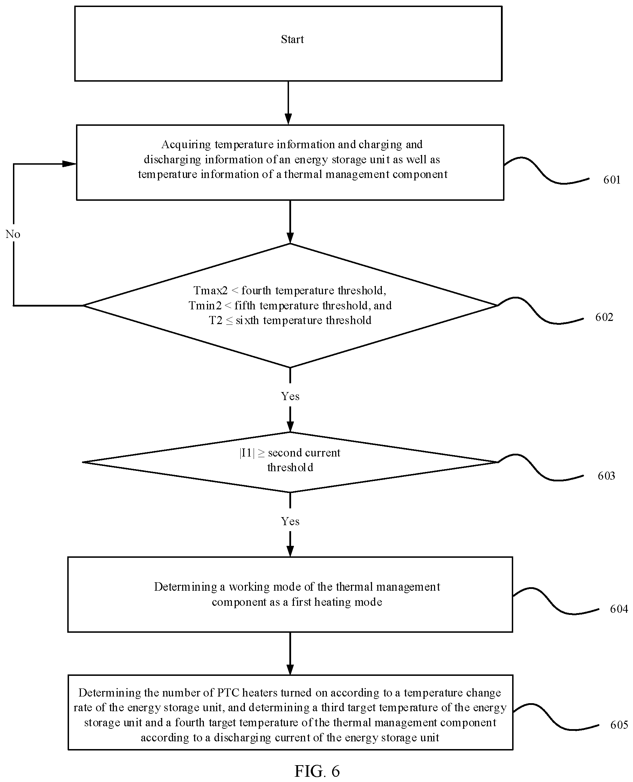

Optionally, in an embodiment of the present application, the heating mode of the thermal management component may be a first heating mode, and specifically, the working mode of the thermal management component is determined as the first heating mode under the circumstance that the absolute value of the discharging current of the energy storage unit is not less than a second current threshold. Reference is made to FIG. 6, Steps 601-602 in FIG. 6 are similar to Steps 501-502 in the above-mentioned embodiment, reference can be made to the above-mentioned embodiment, and for brevity, these steps will not be repeated here.

Step 603 includes determining whether the absolute value |I₁| of the discharging current of the energy storage unit is not less than the second current threshold under the circumstances that the temperature Tₘₐₓ₂ is less than the fourth temperature threshold, the temperature Tₘᵢₙ₂ is less than the fifth temperature threshold, and the temperature T₂ is not greater than the sixth temperature threshold.

Step 604 includes determining the working mode of the thermal management component as the first heating mode under the circumstance that the absolute value |I₁| is not less than the second current threshold.

The second current threshold is a current parameter preset by the energy storage system, and when the absolute value |I₁| of the discharging current of the energy storage unit is not less than the second current threshold, it is indicated that the discharging current of the energy storage unit is relatively large and the energy storage unit is in the discharging state, thereby determining the working mode of the thermal management component as the first heating mode when the energy storage unit is in the discharging state. The current parameter of the second current threshold includes a fixed value, a modifiable value, a value determined through table lookup, and a value determined through functional relationships, which is not limited in the embodiment of the present application.

Step 605 includes determining the number of PTC heaters turned on in the first heating mode according to a temperature change rate of the energy storage unit, and determining a third target temperature of the energy storage unit and a fourth target temperature of the thermal management component in the first heating mode according to a discharging current of the energy storage unit.

The thermal management component includes a plurality of PTC heaters, and each PTC heater includes a PTC ceramic heating element and an aluminum pipe. Such PTC heating bodies have the advantages of low thermal resistance and high heat exchange efficiency, and are electric heaters capable of achieving automatic constant temperature and saving electricity. The PTC heaters can only be turned on or turned off, and the heating power of the single PTC heater cannot be adjusted, so that the heating power of the thermal management component is controlled by controlling the number of the PTC heaters turned on. The heating power of the thermal management component in the heating mode is determined according to the temperature change rate of the energy storage unit, during heating of the thermal management component, by means of the reasonable heating power, thermal management on the energy storage unit can be effectively achieved, and meanwhile, the power consumption of the thermal management component can be reduced. The charging and discharging currents of the batteries are closely related to the temperatures of the batteries, the third target temperature of the energy storage unit and the fourth target temperature of the thermal management component in the heating mode are determined according to the charging and discharging currents of the energy storage unit, and the more reasonable control parameters of the thermal management component are determined.

Optionally, in an embodiment of the present application, the thermal management component stops heating under the circumstances that the temperature of the battery having the lowest temperature in the plurality of batteries is not less than the third target temperature and the temperature of the thermal management component is not less than the fourth target temperature.

When the temperature of the battery having the lowest temperature in the plurality of batteries is not less than the third target temperature and the temperature of the thermal management component is not less than the fourth target temperature, a plurality of temperature conditions of the energy storage system reach preset target temperature conditions, the temperature of the energy storage unit is an appropriate working temperature, the temperature thereof is not required to be adjusted, and thus the thermal management component stops heating.

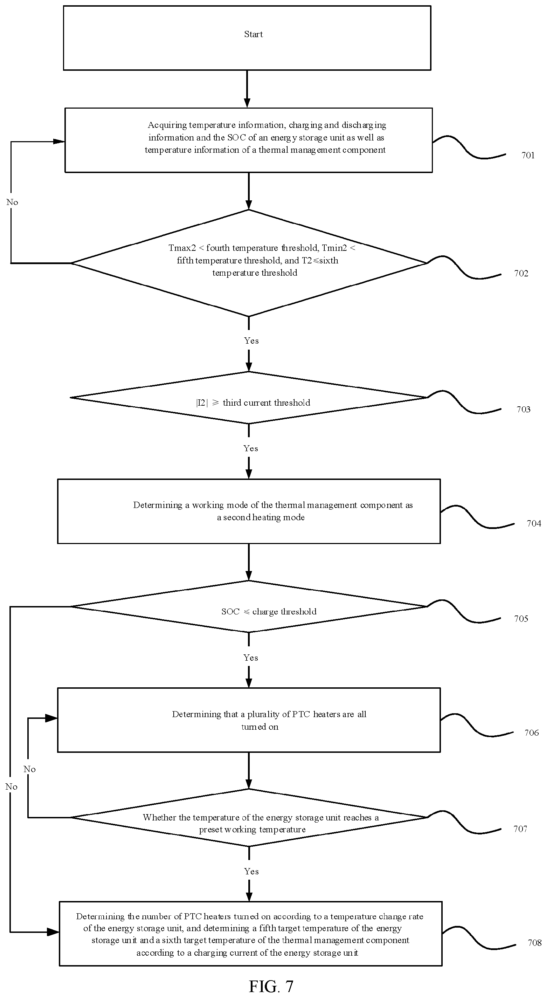

Optionally, in an embodiment of the present application, the heating mode of the thermal management component may be a second heating mode, and specifically, the working mode of the thermal management component is determined as the second heating mode under the circumstance that the absolute value of the charging current of the energy storage unit is not less than a third current threshold. Reference is made to FIG. 7, Steps 701-702 in FIG. 7 are similar to Steps 601-602 in the above-mentioned embodiment, reference can be made to the above-mentioned embodiment, and for brevity, these steps will not be repeated here.

Step 703 includes determining whether the absolute value |I₂| of the charging current of the energy storage unit is not less than the third current threshold under the circumstances that the temperature Tₘₐₓ₂ is less than the fourth temperature threshold, the temperature Tₘᵢₙ₂ is less than the fifth temperature threshold, and the temperature T₂ is not greater than the sixth temperature threshold.

Step 704 includes determining the working mode of the thermal management component as the second heating mode under the circumstance that the absolute value |I₂| is not less than the third current threshold.

The third current threshold is a current parameter preset by the energy storage system, and when the absolute value |I₂| of the charging current of the energy storage unit is not less than the third current threshold, it is indicated that the charging current of the energy storage unit is relatively large and the energy storage unit is in the charging state, thereby determining the working mode of the thermal management component as the second heating mode when the energy storage unit is in the charging state. The current parameter of the third current threshold includes a fixed value, a modifiable value, a value determined through table lookup, and a value determined through functional relationships, which is not limited in the embodiment of the present application.

Step 705 includes determining whether the SOC of the energy storage unit is not greater than a charge threshold.

Step 706 includes determining that the plurality of PTC heaters are all turned on under the circumstance that the SOC of the energy storage unit is not greater than the charge threshold.

The state information of the energy storage system further includes the SOC of the energy storage unit, and the SOC of each battery is a physical quantity for reflecting the remaining capacity of the battery and represents the ratio of the remaining capacity of the battery after being used for a period of time or being not used for a long term to the capacity of the battery in the fully charged state. When the batteries are in the charging state, the charging rate thereof is greatly related to the temperature of the batteries and the SOC of the batteries, and the charging rate of the batteries can be greatly increased at the appropriate working temperature particularly when the SOC is very low. Therefore, the SOC is used as a determining condition, when the SOC is not greater than the charge threshold, it is determined that the plurality of PTC heaters are all turned on to increase the temperature of the energy storage unit as soon as possible so as to enable the temperature to reach the preset working temperature, thereby increasing the charging rate of the batteries; and when the SOC is greater than the charge threshold, that is, the remaining capacity of the batteries is relatively large, the charging rate of the batteries is less affected by the temperature, and thus the plurality of PTC heaters are not required to be completely turned on.

Step 707 includes determining whether the temperature of the energy storage unit reaches a preset working temperature.

Step 708 includes determining the number of the PTC heaters turned on in the second heating mode according to the temperature change rate of the energy storage unit under the circumstance that the temperature of the energy storage unit reaches the preset working temperature, and determining the fifth target temperature of the energy storage unit and the sixth target temperature of the thermal management component in the second heating mode according to the charging current of the energy storage unit.

When the temperature of the energy storage unit reaches the preset working temperature, the plurality of PTC heaters of the thermal management component are not required to be completely turned on, at this moment, the heating power of the thermal management component in the heating mode is determined according to the temperature change rate of the energy storage unit, during heating of the thermal management component, by means of the reasonable heating power, thermal management on the energy storage unit can be effectively achieved, and meanwhile, the power consumption of the thermal management component can be reduced. The charging and discharging currents of the batteries are closely related to the temperatures of the batteries, the fifth target temperature of the energy storage unit and the sixth target temperature of the thermal management component in the heating mode are determined according to the charging current of the energy storage unit, and the more reasonable control parameters of the thermal management component are determined.

Optionally, in an embodiment of the present application, the thermal management component stops heating under the circumstances that the temperature of the battery having the lowest temperature in the plurality of batteries is not less than the fifth target temperature and the temperature of the thermal management component is not less than the sixth target temperature.

When the temperature of the battery having the lowest temperature in the plurality of batteries is not less than the fifth target temperature and the temperature of the thermal management component is not less than the sixth target temperature, a plurality of temperature conditions of the energy storage system reach preset target temperature conditions, the temperature of the energy storage unit is an appropriate working temperature, the temperature thereof is not required to be adjusted, and thus the thermal management component stops heating.

Optionally, in an embodiment of the present application, the working mode of the thermal management component is determined as a self-circulation mode under the circumstances that the energy storage unit is in a working state and the temperature of the energy storage unit and the temperature of the thermal management component reach the target temperatures.

The self-circulation mode means that the thermal management component is in a standby state and cannot perform thermal management on the energy storage unit, that is, when the temperature of the energy storage unit and the temperature of the thermal management component reach the target temperatures and the energy storage unit and the thermal management component continue to work, the thermal management component is not required to perform thermal management on the energy storage unit. At this moment, the state information of the energy storage system is still monitored in real time, when the temperature of the energy storage unit and the temperature of the thermal management component change and affect the working efficiency of the energy storage system, the thermal management component is in the working mode again to perform thermal management on the energy storage unit.

Optionally, in an embodiment of the present application, the thermal management component is in an off state under the circumstance that the energy storage unit is in a standing state.

When the energy storage unit does not work and is in the standing state, the thermal management component is also not required to be turned on, and thus the power consumption of the system can be reduced.

The methods for thermal management of the energy storage system according to the embodiments of the present application are described above, the energy storage system according to the embodiments of the present application will be described below, and reference can be made to the above-mentioned embodiments for the parts not described in detail.

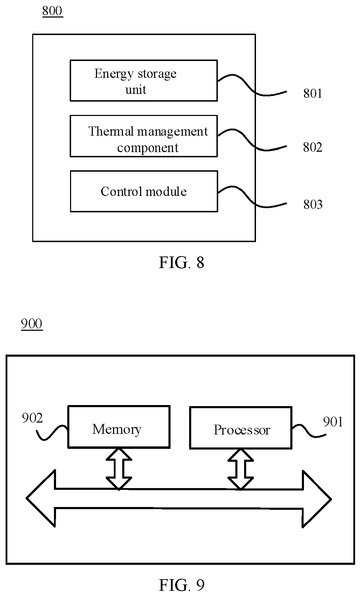

FIG. 8 is a schematic diagram of an energy storage system 800 disclosed in an embodiment of the present application. In the embodiment of the present application, the energy storage system 800 includes an energy storage unit 801, a thermal management component 802 and a control module 803.

The control module 803 is configured to acquire state information of the energy storage system 800 and to determine a thermal management strategy of the energy storage system 800 according to the state information.

Specifically, the state information includes temperature information and charging and discharging information of the energy storage unit 801 as well as temperature information of the thermal management component 802.

In an embodiment of the present application, the thermal management strategy of the energy storage system is determined according to the acquired temperature information and charging and discharging information of the energy storage unit 801 as well as the acquired temperature information of the thermal management component 802. Compared with the solution of determining the thermal management strategy of the energy storage system according to the temperatures of the batteries and the ambient temperature of the system in the prior art, the solution in the present application comprehensively considers the temperature information of the energy storage unit 801 and the thermal management component 802 and the charging and discharging information of the energy storage unit 801, the thermal management strategy of the energy storage system is determined according to such state information, such thermal management strategy is more reasonable, thermal management can be performed on the energy storage system more effectively, the performance of the batteries can be improved, the service life of the batteries can be prolonged, and the unnecessary power consumption of the system in the thermal management process can also be reduced.

Optionally, in an embodiment of the present application, the control module 803 can directly acquire the state information of the energy storage system 800 and can also acquire the state information of the energy storage system 800 by means of a BMS, and the control module 803 and the BMS can be arranged separately and can also be arranged integrally, which is not limited in the present application.

Optionally, in an embodiment of the present application, the control module 803 is configured to determine a working mode of the thermal management component 802 according to the temperature information of the energy storage unit 801 and the temperature information of the thermal management component 802, and to determine control parameters of the thermal management component 802 in the working mode according to the temperature information and the charging and discharging information of the energy storage unit 801.

Optionally, in an embodiment of the present application, the working mode of the thermal management component 802 may include a heating mode or a refrigerating mode.

Optionally, in an embodiment of the present application, the energy storage unit 801 includes a plurality of batteries; and the control module 803 determines the working mode of the thermal management component 802 as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component 802 is not less than a third temperature threshold.

Optionally, in an embodiment of the present application, the control module 803 determines refrigerating power of the thermal management component 802 in the refrigerating mode according to a temperature change rate and charging and discharging currents of the energy storage unit 801, and determines a first target temperature of the energy storage unit 801 and a second target temperature of the thermal management component 802 in the refrigerating mode according to the charging and discharging currents of the energy storage unit 801.

Optionally, in an embodiment of the present application, the control module 803 calculates the refrigerating power of the thermal management component 802 as first refrigerating power according to the temperature change rate of the energy storage unit 801, calculates the refrigerating power of the thermal management component 802 as second refrigerating power according to the charging and discharging currents of the energy storage unit 801, determines the refrigerating power of the thermal management component 802 in the refrigerating mode as the first refrigerating power under the circumstance that the first refrigerating power is higher than the second refrigerating power, and determines the refrigerating power of the thermal management component 802 in the refrigerating mode as an average of the first refrigerating power and the second refrigerating power under the circumstance that the first refrigerating power is lower than the second refrigerating power.

Optionally, in an embodiment of the present application, the first target temperature includes a highest target temperature and a lowest target temperature, and the control module 803 determines the highest target temperature and the lowest target temperature of the energy storage unit 801 in the refrigerating mode according to the charging and discharging currents of the energy storage unit 801.

Optionally, in an embodiment of the present application, the thermal management component 802 stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component 802 is not greater than the second target temperature.

Optionally, in an embodiment of the present application, the control module 803 determines charging and discharging states of the energy storage unit 801 according to the charging and discharging currents of the energy storage unit 801.

Optionally, in an embodiment of the present application, the control module 803 determines that the energy storage unit 801 is in the charging and discharging states under the circumstance that absolute values of the charging and discharging currents of the energy storage unit 801 are not less than a first current threshold.

Optionally, in an embodiment of the present application, the control module 803 determines the working mode of the thermal management component 802 as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component 802 is not greater than a sixth temperature threshold.

Optionally, in an embodiment of the present application, the control module 803 determines the working mode of the thermal management component 802 as a first heating mode under the circumstance that the absolute value of the discharging current of the energy storage unit 801 is not less than a second current threshold.

Optionally, in an embodiment of the present application, the thermal management component 802 includes a plurality of PTC heaters; and the control module 803 determines the number of PTC heaters turned on in the first heating mode according to the temperature change rate of the energy storage unit 801, and determines a third target temperature of the energy storage unit 801 and a fourth target temperature of the thermal management component 802 in the first heating mode according to the discharging current of the energy storage unit 801.

Optionally, in an embodiment of the present application, the thermal management component 802 stops heating under the circumstances that the temperature of the battery having the lowest temperature in the plurality of batteries is not less than the third target temperature and the temperature of the thermal management component 802 is not less than the fourth target temperature.

Optionally, in an embodiment of the present application, the control module 803 determines the working mode of the thermal management component 802 as a second heating mode under the circumstance that the absolute value of the charging current of the energy storage unit 801 is not less than a third current threshold.

Optionally, in an embodiment of the present application, the state information of the energy storage system further includes the SOC of the energy storage unit 801; and the control module 803 determines that the plurality of PTC heaters are all turned on to enable the temperature of the energy storage unit 801 to reach a preset working temperature under the circumstance that the SOC of the energy storage unit 801 is not greater than a charge threshold.

Optionally, in an embodiment of the present application, the control module 803 determines the number of the PTC heaters turned on in the second heating mode according to the temperature change rate of the energy storage unit 801 under the circumstance that the temperature of the energy storage unit 801 reaches the preset working temperature, and determines a fifth target temperature of the energy storage unit 801 and a sixth target temperature of the thermal management component 802 in the second heating mode according to the charging current of the energy storage unit 801.

Optionally, in an embodiment of the present application, the thermal management component 802 stops heating under the circumstances that the temperature of the battery having the lowest temperature in the plurality of batteries is not less than the fifth target temperature and the temperature of the thermal management component 802 is not less than the sixth target temperature.

Optionally, in an embodiment of the present application, the control module 803 determines the working mode of the thermal management component 802 as a self-circulation mode under the circumstances that the energy storage unit 801 is in a working state and the temperature of the energy storage unit 801 and the temperature of the thermal management component 802 reach the target temperatures.

Optionally, in an embodiment of the present application, the control module 803 determines that the thermal management component 802 is in an off state under the circumstance that the energy storage unit 801 is in a standing state.

An embodiment of the present application further provides a device 900 for thermal management of an energy storage system. As shown in FIG. 9, the device 900 includes a processor 901 and a memory 902, wherein the memory 902 is configured to store a computer program; and the processor 901 is configured to call the computer program so as to enable the device to implement the methods according to the various embodiments of the present application.

The embodiments of the present application also provide a readable storage medium for storing a computer program which, when being executed by the computing device, enables the computing device to implement the aforementioned methods of the various embodiments of the present application.

Although the present application has been described with reference to the preferred embodiments, various improvements may be made thereto and components therein may be replaced with equivalents without departing from the scope of the present application. In particular, the various technical features mentioned in the various embodiments may be combined in any manner so long as there is no structural conflict. The present application is not restricted to the particular embodiments disclosed herein, but to include all the technical solutions falling within the scope of the claims.

## Claims

1. A method for thermal management of an energy storage system, the method comprising:
acquiring state information of the energy storage system, wherein the state information comprises temperature information and charging and discharging information of an energy storage unit of the energy storage system as well as temperature information of a thermal management component of the energy storage system; and
determining a thermal management strategy of the energy storage system according to the state information.

2. The method according to claim 1, wherein the determining a thermal management strategy of the energy storage system according to the state information comprises:
determining a working mode of the thermal management component according to the temperature information of the energy storage unit and the temperature information of the thermal management component; and
determining control parameters of the thermal management component in the working mode according to the temperature information and the charging and discharging information of the energy storage unit,
wherein the working mode comprises a heating mode or a refrigerating mode.

3. The method according to claim 2, wherein the energy storage unit comprises a plurality of batteries; and the determining a working mode of the thermal management component according to the temperature information of the energy storage unit and the temperature information of the thermal management component comprises:
determining the working mode of the thermal management component as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component is not less than a third temperature threshold.

4. The method according to claim 3, wherein the determining control parameters of the thermal management component in the working mode according to the temperature information and the charging and discharging information of the energy storage unit comprises:
determining refrigerating power of the thermal management component in the refrigerating mode according to a temperature change rate and charging and discharging currents of the energy storage unit; and
determining a first target temperature of the energy storage unit and a second target temperature of the thermal management component in the refrigerating mode according to the charging and discharging currents of the energy storage unit.

5. The method according to claim 4, wherein the determining refrigerating power of the thermal management component in the refrigerating mode according to a temperature change rate and charging and discharging currents of the energy storage unit comprises:
calculating the refrigerating power of the thermal management component as first refrigerating power according to the temperature change rate of the energy storage unit;
calculating the refrigerating power of the thermal management component as second refrigerating power according to the charging and discharging currents of the energy storage unit;
determining the refrigerating power of the thermal management component in the refrigerating mode as the first refrigerating power under the circumstance that the first refrigerating power is higher than the second refrigerating power; and
determining the refrigerating power of the thermal management component in the refrigerating mode as an average of the first refrigerating power and the second refrigerating power under the circumstance that the first refrigerating power is lower than the second refrigerating power.

6. The method according to claim 4 or 5, wherein the determining a first target temperature of the energy storage unit in the refrigerating mode according to the charging and discharging currents of the energy storage unit comprises:
determining a highest target temperature and a lowest target temperature of the energy storage unit in the refrigerating mode according to the charging and discharging currents of the energy storage unit.

7. The method according to claim 6,
wherein the thermal management component stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature.

8. The method according to any one of claims 3-7, further comprising:
determining charging and discharging states of the energy storage unit according to the charging and discharging currents of the energy storage unit.

9. The method according to claim 8, wherein the determining charging and discharging states of the energy storage unit according to the charging and discharging currents of the energy storage unit comprises:
determining that the energy storage unit is in the charging and discharging states under the circumstance that absolute values of the charging and discharging currents of the energy storage unit are not less than a first current threshold.

10. The method according to any one of claims 2-9, wherein the energy storage unit comprises the plurality of batteries; and the determining a working mode of the thermal management component according to the temperature information of the energy storage unit and the temperature information of the thermal management component comprises:
determining the working mode of the thermal management component as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component is not greater than a sixth temperature threshold.

11. The method according to claim 10, wherein the determining the working mode of the thermal management component as the heating mode comprises:
determining the working mode of the thermal management component as a first heating mode under the circumstance that the absolute value of the discharging current of the energy storage unit is not less than a second current threshold.

12. The method according to claim 11, wherein the thermal management component comprises a plurality of positive temperature coefficient (PTC) heaters; and the determining control parameters of the thermal management component in the working mode according to the temperature information and the charging and discharging information of the energy storage unit comprises:
determining the number of the PTC heaters turned on in the first heating mode according to the temperature change rate of the energy storage unit; and
determining a third target temperature of the energy storage unit and a fourth target temperature of the thermal management component in the first heating mode according to the discharging current of the energy storage unit.

13. The method according to claim 12,
wherein the thermal management component stops heating under the circumstances that the temperature of the battery having the lowest temperature in the plurality of batteries is not less than the third target temperature and the temperature of the thermal management component is not less than the fourth target temperature.

14. The method according to any one of claims 10-13, wherein the determining the working mode of the thermal management component as the heating mode comprises:
determining the working mode of the thermal management component as a second heating mode under the circumstance that the absolute value of the charging current of the energy storage unit is not less than a third current threshold.

15. The method according to claim 14, wherein the state information further comprises the state of charge (SOC) of the energy storage unit; the thermal management component comprises the plurality of PTC heaters; and the method further comprises:
under the circumstance that the SOC of the energy storage unit is not greater than a charge threshold, determining that the plurality of PTC heaters are all turned on to enable the temperature of the energy storage unit to reach a preset working temperature.

16. The method according to claim 15, wherein the determining control parameters of the thermal management component in the working mode according to the temperature information and the charging and discharging information of the energy storage unit comprises:
under the circumstance that the temperature of the energy storage unit reaches the preset working temperature, determining the number of the PTC heaters turned on in the second heating mode according to the temperature change rate of the energy storage unit; and
determining a fifth target temperature of the energy storage unit and a sixth target temperature of the thermal management component in the second heating mode according to the charging current of the energy storage unit, wherein the fifth target temperature is greater than the preset working temperature.

17. The method according to claim 16,
wherein the thermal management component stops heating under the circumstances that the temperature of the battery having the lowest temperature in the plurality of batteries is not less than the fifth target temperature and the temperature of the thermal management component is not less than the sixth target temperature.

18. The method according to any one of claims 1-17, further comprising:
determining the working mode of the thermal management component as a self-circulation mode under the circumstances that the energy storage unit is in a working state and the temperature of the energy storage unit and the temperature of the thermal management component reach the target temperatures.

19. The method according to any one of claims 1-18,
the thermal management component is in an off state under the circumstance that the energy storage unit is in a standing state.

20. An energy storage system, comprising:
an energy storage unit;
a thermal management component; and
a control module configured to acquire state information of the energy storage system and to determine a thermal management strategy of the energy storage system according to the state information,
wherein the state information comprises temperature information and charging and discharging information of the energy storage unit as well as temperature information of the thermal management component.

21. The energy storage system according to claim 20, wherein the control module is configured to:
determine a working mode of the thermal management component according to the temperature information of the energy storage unit and the temperature information of the thermal management component; and
determine control parameters of the thermal management component in the working mode according to the temperature information and the charging and discharging information of the energy storage unit,
wherein the working mode comprises a heating mode or a refrigerating mode.

22. The energy storage system according to claim 21, wherein the energy storage unit comprises a plurality of batteries; and the control module is configured to:
determine the working mode of the thermal management component as the refrigerating mode under the circumstances that the temperature of the battery having the highest temperature in the plurality of batteries is greater than a first temperature threshold, the temperature of the battery having the lowest temperature in the plurality of batteries is greater than a second temperature threshold, and the temperature of the thermal management component is not less than a third temperature threshold.

23. The energy storage system according to claim 22, wherein the control module is configured to:
determine refrigerating power of the thermal management component in the refrigerating mode according to a temperature change rate and charging and discharging currents of the energy storage unit; and
determine a first target temperature of the energy storage unit and a second target temperature of the thermal management component in the refrigerating mode according to the charging and discharging currents of the energy storage unit.

24. The energy storage system according to claim 23, wherein the control module is configured to:
calculate the refrigerating power of the thermal management component as first refrigerating power according to the temperature change rate of the energy storage unit;
calculate the refrigerating power of the thermal management component as second refrigerating power according to the charging and discharging currents of the energy storage unit;
determine the refrigerating power of the thermal management component in the refrigerating mode as the first refrigerating power under the circumstance that the first refrigerating power is higher than the second refrigerating power; and
determine the refrigerating power of the thermal management component in the refrigerating mode as an average of the first refrigerating power and the second refrigerating power under the circumstance that the first refrigerating power is lower than the second refrigerating power.

25. The energy storage system according to claim 23 or 24, wherein the first target temperature comprises a highest target temperature and a lowest target temperature; and the control module is configured to:
determine the highest target temperature and the lowest target temperature of the energy storage unit in the refrigerating mode according to the charging and discharging currents of the energy storage unit.

26. The energy storage system according to claim 25,
wherein the thermal management component stops refrigeration under the circumstances that the temperature of the battery having the highest temperature in the plurality of batteries is not greater than the highest target temperature or the temperature of the battery having the lowest temperature in the plurality of batteries is not greater than the lowest target temperature, and the temperature of the thermal management component is not greater than the second target temperature.

27. The energy storage system according to any one of claims 22-26, wherein the control module is also configured to:
determine charging and discharging states of the energy storage unit according to the charging and discharging currents of the energy storage unit.

28. The energy storage system according to claim 27, wherein the control module is configured to:
determine that the energy storage unit is in the charging and discharging states under the circumstance that absolute values of the charging and discharging currents of the energy storage unit are not less than a first current threshold.

29. The energy storage system according to any one of claims 21-28, wherein the energy storage unit comprises the plurality of batteries; and the control module is configured to:
determine the working mode of the thermal management component as the heating mode under the circumstances that the temperature of the battery having the highest temperature in the plurality of batteries is less than a fourth temperature threshold, the temperature of the battery having the lowest temperature in the plurality of batteries is less than a fifth temperature threshold, and the temperature of the thermal management component is not greater than a sixth temperature threshold.

30. The energy storage system according to claim 29, wherein the control module is configured to:
determine the working mode of the thermal management component as a first heating mode under the circumstance that the absolute value of the discharging current of the energy storage unit is not less than a second current threshold.

31. The energy storage system according to claim 30, wherein the thermal management component comprises a plurality of positive temperature coefficient (PTC) heaters; and the control module is configured to:
determine the number of the PTC heaters turned on in the first heating mode according to the temperature change rate of the energy storage unit; and
determine a third target temperature of the energy storage unit and a fourth target temperature of the thermal management component in the first heating mode according to the discharging current of the energy storage unit.

32. The energy storage system according to claim 31,
wherein the thermal management component stops heating under the circumstances that the temperature of the battery having the lowest temperature in the plurality of batteries is not less than the third target temperature and the temperature of the thermal management component is not less than the fourth target temperature.

33. The energy storage system according to any one of claims 29-32, wherein the control module is configured to:
determine the working mode of the thermal management component as a second heating mode under the circumstance that the absolute value of the charging current of the energy storage unit is not less than a third current threshold.

34. The energy storage system according to claim 33, wherein the state information further comprises the state of charge (SOC) of the energy storage unit; the thermal management component comprises the plurality of PTC heaters; and the control module is also configured to:
under the circumstance that the SOC of the energy storage unit is not greater than a charge threshold, determine that the plurality of PTC heaters are all turned on to enable the temperature of the energy storage unit to reach a preset working temperature.

35. The energy storage system according to claim 34, wherein the control module is configured to:
under the circumstance that the temperature of the energy storage unit reaches the preset working temperature, determine the number of the PTC heaters turned on in the second heating mode according to the temperature change rate of the energy storage unit; and
determine a fifth target temperature of the energy storage unit and a sixth target temperature of the thermal management component in the second heating mode according to the charging current of the energy storage unit.

36. The energy storage system according to claim 35,
wherein the thermal management component stops heating under the circumstances that the temperature of the battery having the lowest temperature in the plurality of batteries is not less than the fifth target temperature and the temperature of the thermal management component is not less than the sixth target temperature.

37. The energy storage system according to any one of claims 20-36, wherein the control module is also configured to:
determine the working mode of the thermal management component as a self-circulation mode under the circumstances that the energy storage unit is in a working state and the temperature of the energy storage unit and the temperature of the thermal management component reach the target temperatures.

38. The energy storage system according to any one of claims 20-37,
wherein the thermal management component is in an off state under the circumstance that the energy storage unit is in a standing state.

39. A device for thermal management of an energy storage system, the device comprising a processor and a memory, wherein the memory is configured to store a computer program; and the processor is configured to call the computer program so as to enable the device to implement the method according to any one of claims 1-19.

40. A readable storage medium, wherein the readable storage medium stores a computer program which, when being executed by a computing device, enables the computing device to implement the method according to any one of claims 1-19.
